# DEMANDE DE BREVET EUROPEEN

(11) **EP 4 390 566 A1**
(43) Date de publication de la demande: **26.06.2024**
(21) Numéro de dépôt: 23220082.4
(22) Date de dépôt: 22.12.2023
(51) Int. Cl.: G04B 19/30, G04G 17/02, G04G 9/00, G04G 17/00, G04G 17/04, G04G 21/00, G04G 21/02, G04G 99/00

(54) **DISPOSITIF DE DÉTERMINATION D'UN ÉVÈNEMENT ACOUSTIQUE D'UN CADRAN DE MONTRE**

(30) Priorité: 22.12.2022 EP 22215943
(71) Demandeur: ETA SA Manufacture Horlogère Suisse, 2540 Grenchen (CH)
(72) Inventeur: DUBUGNON, Dominique, 1162 Saint-Prex (CH); TORTORA, Pierpasquale, 2000 Neuchâtel (CH); HUOT-MARCHAND, Sylvain, 2743 Eschert (CH); COURVOISIER, Raphaël, 2035 Corcelles (CH)
(74) Mandataire: ICB SA

(57) **Abrégé**

Un aspect de l'invention concerne un cadran (2a, 2b) de montre (1) comprenant un dispositif de détermination d'un évènement acoustique autonome (3), un tel cadran (2a, 2b) comprend une face visible (20a) et une face cachée (20b), ledit cadran (2a, 2b) étant formé par un empilement (9a, 9b) de couches minces (10, 11, 12, 13, 14) de matière s'étendant entre ces deux faces (20a, 20b), chacune desdites couches (10, 11, 12, 13, 14) comprenant un ou plusieurs des éléments fonctionnels compris dans ledit dispositif 3) :
- au moins un élément récepteur (23) d'au moins une onde acoustique provenant de la montre (1) ;
- un module de signalement de l'évènement acoustique (4) ;
- une unité d'alimentation électrique autonome (21) ; et
- une unité de contrôle (7) pour gérer le fonctionnement dudit module de signalement (4) et dudit au moins un élément récepteur (23) d'au moins une onde acoustique.

## Description

### Domaine technique de l'invention

La présente invention concerne une montre comportant un cadran incluant un dispositif de détermination d'un évènement acoustique totalement autonome.

### Arrière-plan technologique

Dans l'art antérieur, on connaît des montres électromécaniques à aiguilles dans lesquelles l'aiguille des heures et l'aiguille des minutes d'affichage de l'heure courante sont entraînées par des rouages d'un mécanisme d'un mouvement horloger. Dans ce contexte, il peut arriver qu'en raison des chocs subis par la montre, le fonctionnement du mécanisme s'en trouve perturbé. Ceci a pour conséquence que, bien que l'horloge interne de la montre fournisse une indication juste de l'heure courante, les aiguilles d'heures et de minutes fournissent une indication faussée de cette heure courante sous l'effet de la perturbation externe appliquée à la montre. Il peut donc être nécessaire de resynchroniser la position des aiguilles d'heures et de minutes.

Dans ce contexte, on comprend qu'il existe un besoin de trouver une solution, qui ne présente pas les inconvénients de l'art antérieur.

### Résumé de l'invention

L'invention a pour but de pallier ces inconvénients en proposant une montre pourvue d'un cadran comportant un dispositif de détermination d'un évènement acoustique qui soit autonome et qui présente une efficacité qui reste constante dans le temps.

Un aspect de l'invention concerne un cadran de montre comprenant un dispositif de détermination d'un évènement acoustique autonome, un tel cadran comprend une face visible et une face cachée, ledit cadran étant formé par un empilement de couches minces de matière s'étendant entre ces deux faces, chacune desdites couches comprenant un ou plusieurs des éléments fonctionnels compris dans ledit dispositif :
- au moins un élément récepteur d'au moins une onde acoustique provenant de la montre ;
- un module de signalement de l'évènement acoustique ;
- une unité d'alimentation électrique autonome ; et
une unité de contrôle pour gérer le fonctionnement dudit module de signalement et dudit au moins un élément récepteur d'au moins une onde acoustique.

Dans d'autres modes de réalisation :
- ledit au moins un élément récepteur comprend un microphone à pression et/ou un microphone à gradient de pression ;
- le module de signalement de l'évènement acoustique comprend au moins un élément susceptible de générer un signal lumineux ;
- le module de signalement de l'évènement acoustique comprend au moins un élément susceptible de générer un signal vibratoire ;
- le module de signalement de l'évènement acoustique comprend au moins un élément susceptible de générer un signal sonore ;
- l'empilement de couches minces de matière comprend une première couche pourvue de la face visible du cadran et comprenant ledit au moins un élément récepteur et ladite au moins une source lumineuse ;
- ledit au moins un élément récepteur est agencé dans une cavité ménagée dans la face cachée de ce cadran ;
- ladite première couche est configurée pour être traversé en tout ou partie par un rayonnement lumineux notamment par un rayonnement solaire ;
- ladite première couche est en tout ou partie transparente ou translucide ;
- l'empilement de couches minces de matière comporte une deuxième couche comprenant un module photovoltaïque constituant l'unité d'alimentation électrique autonome ;
- la deuxième couche comprend un substrat sur lequel le module photovoltaïque est imprimé ;
- ledit module photovoltaïque est disposé sur une zone active de ladite deuxième couche, ladite zone étant configurée pour recevoir des rayonnements lumineux provenant de la première couche de l'empilement de couches minces de matière ;
- l'empilement comporte une troisième couche comprenant un accumulateur d'énergie électrique constituant l'unité d'alimentation électrique autonome ;
- la troisième couche comprend un substrat sur lequel l'accumulateur d'énergie électrique est imprimé ;
- l'empilement comporte une quatrième couche formant une face cachée du cadran comprenant l'unité de contrôle ;
- l'empilement comporte une troisième couche comprenant une face cachée du cadran comportant l'unité de contrôle et un accumulateur d'énergie électrique constituant l'unité d'alimentation électrique autonome ;
- la première couche est rigide relativement aux autres couches comprises dans l'empilement de couches minces de matière qui sont souples ;
- lesdites faces visible et. cachée sont planes ou bombées.

Un autre aspect de l'invention concerne une montre comprenant un tel cadran.

Avantageusement, la montre comprend un mouvement horloger mécanique électronique ou électromécanique.

### Brève description des figures

Les buts, avantages et caractéristiques de la montre selon l'invention apparaîtront mieux dans la description suivante sur la base d'au moins une forme d'exécution non limitative illustrée par les dessins sur lesquels :
- la figure 1 représente une vue en perspective d'une montre comprenant un cadran pourvu d'un dispositif de détermination d'un évènement acoustique qui est autonome et compris dans la montre, selon des modes de réalisation de l'invention ;
- la figure 2 représente une vue éclatée d'une première variante du cadran formé d'un empilement de quatre couches superposées, lesdites couches comportant chacune un ou plusieurs éléments constitutifs du dispositif de détermination d'un évènement acoustique, selon un premier mode de réalisation de l'invention ;
- la figure 3 représente une vue schématique de cette première variante du cadran pourvue du dispositif de détermination d'un évènement acoustique, selon le premier mode de réalisation de l'invention ;
- la figure 4 représente une vue éclatée d'une deuxième variante du cadran formé d'un empilement de trois couches superposées, lesdites couches comportant chacune un ou plusieurs éléments constitutifs du dispositif de détermination d'un évènement acoustique, selon un deuxième mode de réalisation de l'invention ; et
- la figure 5 représente une vue schématique de cette deuxième variante du cadran pourvue du dispositif de détermination d'un évènement acoustique, selon le deuxième mode de réalisation de l'invention.

### Description détaillée de l'invention

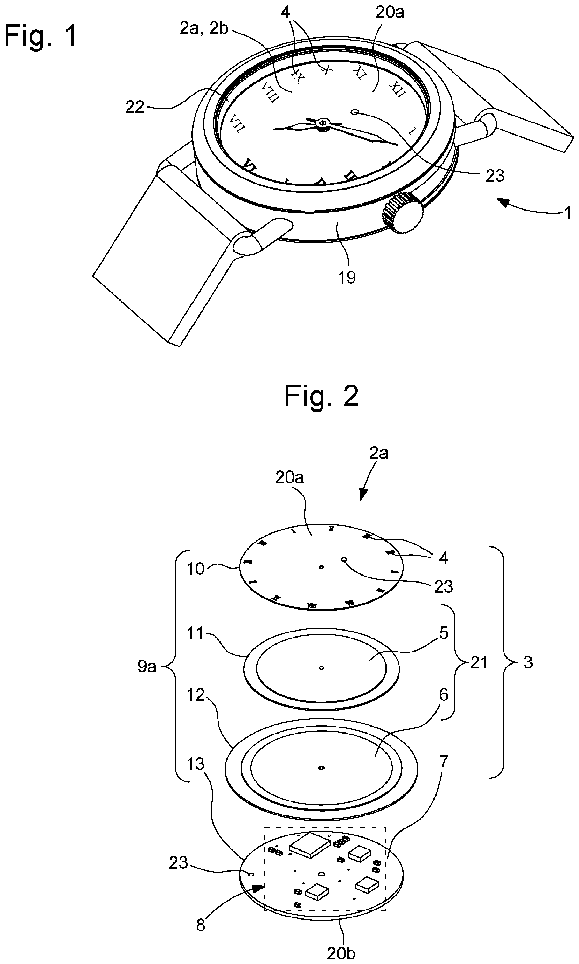

La figure 1 illustre une représentation schématique d'une montre 1 comprenant un boitier 19 pourvu d'une carrure à laquelle sont fixés un fond et une glace 22, d'un ensemble de composants formant un mouvement horloger, et d'un cadran 2a, 2b disposé entre le mouvement horloger et la glace 22.

Le mouvement horloger entraîne de façon connue de l'homme du métier un aiguillage comprenant une aiguille des heures, une aiguille des minutes et éventuellement une aiguille des secondes. À cet effet, le cadran 2a, 2b comporte un trou traversant recevant l'axe des aiguilles. Ce cadran 2a, 2b comprend aussi deux faces 20a, 20b dont :
- une face dite visible 20a de l'extérieur de la montre 1 aussi appelée « *partie visible* » ou « *partie supérieure visible* » de ce cadran 2a, 2b ; et
- une face dite cachée 20b agencée en regard du mouvement horloger dans une enceinte du boitier 19 de la montre 1, cette face 20b étant autrement appelée « *partie* cachée » ou « *partie inférieure* cachée » de ce cadran 2a, 2b.

Une telle face visible 20a peut comprendre de manière non limitative et non exhaustive au moins une représentation graphique telle que :
- un élément de repère (ou d'affichage) comme par exemple un chiffre, un index, un trait ou encore un point contribuant à participer avec/sans les aiguilles à l'affichage d'une information/grandeur horlogère ou d'une information/grandeur physique mesurée par un capteur ou similaire compris dans le mouvement ;
- une inscription, un motif, un texte, un logo, etc.

Ces faces visible 20a et cachée 20b sont sensiblement planes et/ou parallèles et/ou opposées l'une à l'autre. On notera dans d'autres variantes que le cadran 2a, 2b peut comprendre une face visible bombée et une face cachée qui peut être bombée ou plane. Ces faces 20a, 20b sont aussi reliées entre elles par une paroi périphérique de ce cadran 2a, 2b.

On notera par ailleurs que dans les modes de réalisation illustrés sur les figures 1 à 5, le cadran 2a, 2b a de préférence une forme circulaire. On comprend que l'invention peut également être mise en oeuvre pour des cadrans 2a, 2b ayant d'autres formes comme par exemple une forme triangulaire ou encore une forme similaire à celle d'un quadrilatère.

Dans les modes de réalisation de l'invention, le mouvement horloger est un mouvement mécanique. Dans une alternative ce mouvement peut être un mouvement électromécanique. On parlera d'ailleurs par la suite d'une montre mécanique lorsque son mouvement est mécanique et d'une montre électromécanique et électronique lorsqu'elles comportent respectivement des mouvements électromécanique et électronique.

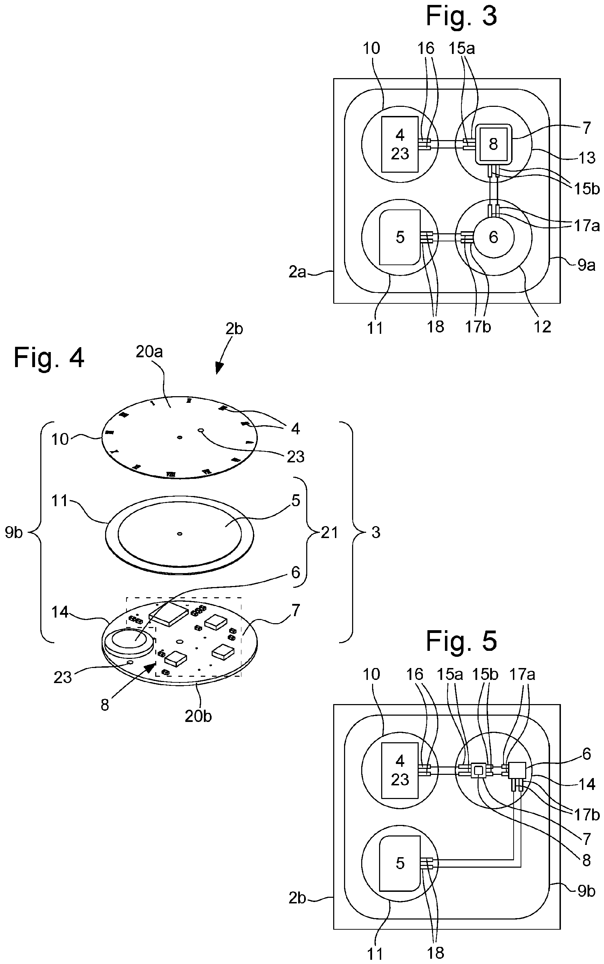

En référence aux figures 2 et 4, un tel cadran 2a, 2b comprend un dispositif de détermination d'un évènement acoustique autonome 3. Ce dispositif de détermination 3 comprend ses propres moyens d'alimentation électrique comme nous le verrons par la suite. Un tel dispositif de détermination d'un évènement acoustique 3 est dit autonome notamment par rapport au mouvement de la montre 1 et en particulier de la source énergétique de ce mouvement, par exemple lorsque cette source est une alimentation électrique comme dans un mouvement électromécanique. Dans ces conditions, on comprend que l'énergie utilisée par ce dispositif de détermination d'un évènement acoustique 3 ne se fait pas au détriment de l'autonomie du mouvement.

Dans ce contexte, le cadran 2a, 2b peut être monté de manière amovible dans la montre 1 quel que soit le type de la montre 1. La seule condition à respecter est que le cadran 2a, 2b comprenne ce dispositif de détermination d'un évènement acoustique 3 qui est donc autonome par rapport au mouvement de la montre 1. Ce cadran 2a, 2b est aussi appelé « cadran autonome » car il n'est pas connecté notamment électriquement au mouvement de la montre 1.

Ce dispositif de détermination 3 compris dans ce cadran 2a, 2b, comporte un module de signalement de l'évènement acoustique 4, une unité d'alimentation électrique autonome 21, au moins un élément récepteur 23 d'au moins une onde acoustique, et une unité de contrôle 7.

Dans ce dispositif 3, le module de signalement 4 comprend :
- au moins un élément susceptible de générer un signal lumineux 4, tel qu'une source lumineuse 4 aussi appelée source de lumière, permettant au dispositif 3 de diffuser un message visuel en rapport avec l'évènement acoustique déterminé ;
- au moins un élément susceptible de générer un signal vibratoire tel qu'un vibreur piézo-électrique, un vibreur comprenant un moteur ERM (pour moteur de vibration à masse rotative excentrique) ou moteur LRA (pour moteur à vibration linéaire), permettant au dispositif 3 de diffuser un message sous forme de vibrations en rapport avec l'évènement acoustique déterminé ; et/ou
- au moins un élément susceptible de générer un signal sonore tel qu'un haut-parleur permettant au dispositif 3 de diffuser un message sonore en rapport avec l'évènement acoustique déterminé.

Ainsi que nous l'avons évoqué, ladite au moins une source lumineuse 4 est mise en oeuvre notamment pour participer à l'affichage d'un message visuel en rapport avec l'évènement acoustique déterminé. Chaque source lumineuse 4 peut correspondre à n'importe quel élément électroluminescent sélectionné dans une liste comprenant de manière non exhaustive et non limitative :
- un condensateur électroluminescent plus connu sous l'acronyme LEC pour « Light-Emitting Capacitor » ;
- une diode électroluminescente de type LED (acronyme de « Light-Emitting Diode »), OLED (acronyme de « Organic Light-Emitting Diode »), AMOLED (acronyme de « Active-Matrix Organic Light-Emitting Diode ») ou encore QLED (acronyme de « Quantum Light-emitting diode » ;
- tout matériau électroluminescent activé par un champ électrique local ;
- tout matériau électroluminescent activé par un courant électrique ;
- toutes combinaisons de ces éléments électroluminescents.

On notera que cette source lumineuse 4 peut dans certains modes de réalisation de l'invention, être une source lumineuse 4 apte à former une source lumineuse étendue. Ceci permet de donner une forme prédéterminée à la source lumineuse étendue, typiquement, sans que cela ne soit exhaustif ni limitatif, une forme relative à une représentation graphique de chiffre, de lettre, de logo ou encore de texte. On notera en complément, que cette source lumineuse 4 peut produire de la lumière dans n'importe quelle couleur et/ou dans n'importe quelle direction.

Dans ce dispositif de détermination d'un évènement acoustique 3, ledit au moins un élément récepteur 23 d'une onde acoustique est configuré pour identifier une telle onde générée par la montre et en particulier par un composant horloger et/ou un mécanisme horloger du mouvement de de cette montre 1.

De manière non limitative et non exhaustive, ce composant horloger peut être :
- un composant d'habillage horloger de la pièce d'horlogerie tel qu'un boitier, une carrure, un cadran, un fond, etc ;
- un composant de mouvement horloger tel qu'une masse oscillante, un rotor, un barillet, un rouage horloger, une platine de mouvement, etc.

Dans cette montre, le mécanisme horloger participe à la mise en oeuvre de la mesure du temps, ou à celle des fonctions ou complications. Il peut s'agir par exemple d'un échappement à ancre.

Cet élément récepteur 23 comprend au moins un transducteur électro-acoustique qui est apte à convertir une onde acoustique en un signal électrique. Cet élément récepteur 23 peut comprendre au moins un microphone à pression ou à gradient de pression généralement pourvu d'une membrane ou d'un élément piézoélectrique qui est apte à se déformer et/ou à se mouvoir sous l'effet d'au moins une onde acoustique.

De manière alternative, cet élément récepteur 23 peut comprendre au moins un microphone optique. Un tel microphone qui est décrit plus en détail dans le document de brevet européen EP2338287B1, est un dispositif qui est apte à convertir une onde acoustique en un signal électrique et ce, à partir d'une technologie basée sur l'interférométrie. Un tel microphone comprend notamment une source de rayonnement électromagnétique, des éléments réfléchissants tels que des miroirs, au moins un détecteur de ce rayonnement électromagnétique et un interféromètre tel qu'un interféromètre Fabry-Pérot ou encore un agencement Gires-Tournois.

On notera que dans une autre variante cet élément récepteur 23 peut comprendre une combinaison quelconque de microphones suivants : au moins un microphone à pression, au moins un microphone à gradient de pression et au moins un microphone optique.

Dans ce dispositif de détermination 3, l'unité d'alimentation électrique autonome 21 comporte un accumulateur d'énergie électrique 6 et un module photovoltaïque 5 comprenant au moins une cellule photovoltaïque encore appelée cellule solaire. Ce module photovoltaïque 5 est relié à l'accumulateur d'énergie électrique 6 via des éléments de connexions référencés 17b et 18 sur les figures 3 et 5. Ce module photovoltaïque 5 peut comprendre une ou des cellules élémentaires du type à hétérojonction ou multijonction, connectées en parallèle ou en série. Chaque cellule photovoltaïque de ce module 5, peut être réalisée, de manière connue de l'homme du métier, à partir de matériaux semi-conducteur à base de cuivre, d'indium, de gallium et de sélénium, à base de tellurure de cadmium, à base d'arséniure de gallium monocristallin ou à base de silicium monocristallin ou polycristallin, ou à pérovskites. Il y a lieu de noter que ces exemples sont non limitatifs et que l'homme du métier saura trouver le type de cellule photovoltaïque adapté à l'invention.

Dans ce dispositif de détermination d'un évènement acoustique 3, l'unité de contrôle 7 aussi appelée microcontrôleur, comporte un circuit électronique 8 comprenant des ressources matérielles en particulier au moins un processeur coopérant avec des éléments de mémoire ainsi que des bus d'adresses, de données et de contrôle. Cette unité de contrôle 7 est connectée à au module de signalement 4, audit au moins un élément récepteur d'au moins une onde acoustique 23 et à l'unité d'alimentation électrique autonome 21. Une telle unité de contrôle 7 comprend dans ses éléments de mémoire un algorithme de détermination d'un évènement acoustique.

Cet algorithme peut faire l'objet d'un entraînement automatique encore appelé apprentissage automatique qui est de préférence supervisé. Plus particulièrement, il s'agit ici d'un algorithme d'apprentissage de détermination d'un évènement acoustique en fonction de caractéristiques de signatures/identités sonores issues du traitement des signaux acoustiques effectué par l'unité de contrôle 7. Un tel algorithme peut comprendre ou mettre en oeuvre au moins un réseau de neurones et/ou une fonction analytique et/ou un principe de régression polynomial. Pour ce faire, l'unité de contrôle 7 qui participe à mettre en oeuvre un tel entrainement, comprend des données d'entraînement de mesures d'ondes acoustiques et des données d'entraînement d'évènements acoustiques déterminés/identifiés relatives à la montre. Cet entraînement vise à améliorer l'algorithme et en particulier le modèle qui en résulte afin de minimiser l'erreur entre « estimation et réalité » dans le cadre de l'évaluation d'un évènement acoustique donné en fonction d'une mesure d'ondes acoustiques relative à cet évènement.

On notera qu'un tel algorithme qui est exécuté par le processeur de cette unité de contrôle 7 peut aussi prendre en compte d'autres types d'évènements afin d'améliorer la détermination de l'évènement acoustique et ce, à partir de données provenant de capteurs d'évènement compris dans ce dispositif de détermination 3. Ces évènements peuvent comprendre de manière non limitative et non exhaustive : la détection d'un niveau de luminosité particulier dans l'environnement de la montre 1, la détection d'un objet visuel particulier, la détection d'un mouvement effectué par une partie du corps de l'utilisateur sur laquelle est comprise cette montre 1, etc. Dans ce contexte, le capteur d'évènement de ce dispositif de détermination 3, comprend en particulier et de manière non limitative et non exhaustive :
- un capteur de luminosité permettant de détecter le niveau de luminosité ambiante ;
- un capteur de mouvement d'une partie du corps de l'utilisateur comprenant la montre 1 tel qu'un capteur gyroscopique et/ou inertiel sous la forme d'un composant électronique de type circuit microsystèmes électromécaniques gyroscopique et/ou inertiel ; et/ou
- un capteur optique de type capteur photographique.

Par ailleurs lorsque le module de signalement 4 comprend plusieurs sources lumineuses 4, le fonctionnement de ces dernières peut alors être géré/contrôlé par l'unité de contrôle 7 de manière simultanée et/ou en séquence. De plus chaque source lumineuse 4 est gérée/contrôlée par cette unité de contrôle 7 de manière distincte. Dans ce contexte, la gestion du fonctionnement de chaque source lumineuse 4 peut consister de manière non limitative et non exhaustive en la réalisation des opérations suivantes : un allumage ou une extinction séquentiel (le), un allumage ou une extinction simultané € de deux ou plusieurs sources lumineuses 4, un clignotement d'une ou de plusieurs sources lumineuses 4, une définition d'une fréquence de clignotement pour chaque source lumineuse 4, une durée de clignotement pour chaque source lumineuse 4, une durée d'allumage ou d'extinction pour chaque source lumineuse 4, etc.

Une telle unité de contrôle 7 peut aussi comprendre dans ses éléments de mémoire un algorithme de gestion de l'accumulateur d'énergie électrique 6 en particulier la gestion de son rechargement par le module photovoltaïque 5 et la gestion de la consommation électrique dudit module de signalement 4 et de l'élément récepteur 23.

Ainsi que nous l'avons évoqué, le dispositif de détermination d'un évènement acoustique autonome 3 est donc compris dans le cadran 2a, 2b. Dans cette configuration, les éléments constitutifs de ce dispositif de détermination 3 à savoir le module de signalement 4, l'accumulateur d'énergie électrique 6, l'élément récepteur 23, le module photovoltaïque 5 et l'unité unité de contrôle 7, sont compris dans une ou plusieurs couches 10, 11, 12, 13, 14 formant ce cadran 2a, 2b.

En référence aux figures 2 à 5, ce cadran 2a, 2b est formé ou constitué par un empilement 9a, 9b d'une pluralité de couches minces/fines 10, 11, 12, 13, 14, ces couches 10, 11, 12, 13, 14 sont reliées entre elles par un élément de liaison tel qu'une substance adhésive de manière à les unifier afin obtenir un empilement 9a, 9b de couches minces monolithique formant ainsi un cadran monobloc 2a, 2b. Cet élément de liaison peut aussi être un clip ou encore une vis. De telles couches 10, 11, 12, 13, 14 sont superposées dans l'empilement 9a, 9b de couches c'est-à-dire qu'elles sont agencées les unes au-dessus des autres dans ce cadran 2a, 2b selon un ordre défini. On notera qu'un tel empilement 9a, 9b de couches peut aussi être appelé un assemblage de couches. Dans cet empilement 9a, 9b, les couches sont sensiblement similaires en présentant des surfaces supérieures et inférieures sensiblement de mêmes aires/superficies participant ainsi à former la paroi périphérique du cadran 2a, 2b qui est dépourvue de relief.

On notera que ces couches minces ou fines sont des couches qui présentent chacune une épaisseur micrométrique. En effet, chaque couche peut présenter une épaisseur comprise entre 1 et 100 µm, de préférence 2 µm, ou de préférence 3 µm. S'agissant de l'épaisseur du cadran 2a, 2b, il peut être compris entre 8 et 400 µm, de préférence 6 µm ou de préférence 12 µm ou de préférence 100 µm ou de préférence 200 µm ou de préférence 300 µm.

Ainsi un tel cadran monobloc 2a, 2b, présente en outre l'avantage de pouvoir être monté de manière amovible dans le boitier 19 de la montre 1 en plus de faciliter son intégration dans ce boitier 19.

Dans une première variante de cet empilement 9a de couches illustré sur la figure 3, ce dernier est constitué de quatre couches minces/fines 10, 11, 12, 13 successives suivantes :
- une première couche 10 formant/constituant la face visible 20a du cadran 2a incluant ledit au moins un élément récepteur 23 et/ou le module de signalement 4 ;
- une deuxième couche 11 incluant le module photovoltaïque 5 ;
- une troisième couche 12 incluant un accumulateur d'énergie électrique 6 aussi appelé batterie rechargeable ; et
- une quatrième couche 13 formant la face cachée 20b du cadran 2a incluant ledit au moins un élément récepteur 23 et/ou l'unité de contrôle 7.

La première couche 10 de cet empilement 9a, est de préférence rigide ou semi-rigide en comparaison avec les deuxième, troisième et quatrième couches minces/fines 11, 12, 13 qui sont de préférences souples ou flexibles. On comprend ici qu'une telle première couche 10 participe à rigidifier de manière structurelle l'empilement 9a de couches minces et donc le cadran 2a.

Dans cet empilement 9a, les première, deuxième, troisième et quatrième couches 10, 11, 12, 13, comprennent chacune une surface supérieure et une surface inférieure.

S'agissant de la première couche 10, elle est formée par un substrat transparent ou translucide ou au moins partiellement transparent ou au moins partiellement translucide qui est rigide ou semi-rigide. Un tel substrat est réalisé en une matière présentant une transmittance aux rayonnements solaires en particulier aux rayonnements ultraviolets aussi appelée UVT (pour « Ultra-Violet Transmission ») qui est comprise entre 65 et 95 pourcent. Cette transmittance est de préférence de 85 pourcent. Une telle matière peut être transparente ou translucide. Cette matière peut être de manière non limitative et non exhaustive un polymère, du verre ou encore de la céramique.

Dans ce contexte, on comprend que ce substrat est configuré pour que :
- la lumière produite par ladite au moins une source lumineuse du module de signalement 4 puisse s'échapper vers l'extérieur du cadran 2a, 2b et donc de la montre 1 ; et
- la lumière provenant de l'environnement de la montre 1 puisse pénétrer dans le cadran 2a, 2b en direction du module photovoltaïque 5 du dispositif de détermination d'un évènement acoustique 3, cette lumière comprenant des rayonnements solaires lorsqu'elle est d'origine naturelle.

Autrement dit, ce substrat transparent ou translucide est configuré pour être traversé par la lumière, notamment un rayonnement solaire, susceptible d'alimenter le module photovoltaïque 5 afin que ce dernier puisse convertir l'énergie solaire provenant de ce rayonnement en énergie électrique.

Cette première couche 10 comprend le module de signalement 4 qui est agencé dans le corps du substrat. Dans cette configuration, l'agencement de la source lumineuse de ce module 4 dans ce substrat est configuré pour assurer un éclairage de tout ou partie de la face visible 20a du cadran 2a. Par exemple, un éclairage d'une représentation graphique telle qu'un élément de repère (ou affichage) comme un chiffre, un index, un trait, un point ou un éclairage d'une ou de plusieurs aiguilles, ou encore un éclairage de tout ou partie de la surface de la face visible du cadran 2a. Dans une variante, cette source lumineuse 4 peut avoir une forme prédéterminée telle que la forme d'un chiffre, d'une lettre, d'un index, d'un trait, d'un point, d'un logo ou encore d'un texte.

Cet éclairage peut être un éclairage de type rétroéclairage ou semi-direct lorsque la source lumineuse 4 est agencée dans une cavité définie dans le substrat. Plus précisément, cette cavité pouvant être une ouverture borgne réalisée dans la surface inférieure de ce substrat. Dans cette configuration, lorsque le fond de cette cavité comprend une représentation graphique, le rayonnement lumineux, ou la lumière, produit par cette source lumineuse 4 peut s'échapper vers l'extérieur du cadran 2a via la face visible 20a de ce cadran 2a, autorisant ainsi la visualisation d'au moins une représentation graphique dan' l'obscurité. En particulier, le rayonnement lumineux en s'échappant ainsi de la face visible 20a, vient dessiner le contour de cette représentation graphique. Dans ce contexte, cette représentation graphique comprise dans ou sur la surface supérieure ou encore sur la surface inférieure du substrat formant la première couche 10, est de préférence opaque ou non translucide ou non transparente.

Cet éclairage peut être un éclairage direct lorsque la source lumineuse 4 est agencée dans une cavité définie dans le substrat. Cette cavité peut être une ouverture borgne réalisée dans la surface inférieure de ce substrat et dont le fond est dépourvu de toute représentation graphique. Dans cette configuration, le rayonnement lumineux, ou la lumière, produit par cette source lumineuse 4 peu' s'échapper par le fond de cette cavité ver' l'extérieur du cadran 2a et donc par la face visible 20a de ce cadran 2a.

Cet éclairage peut aussi être un éclairage direct lorsque la source lumineuse 4 est agencée dans une ouverture traversante s'étendant dans l'épaisseur du substrat de la première couche 10, en débouchant en ses deux extrémités respectivement dans les surfaces supérieure et inférieure de ce substrat. Dans cette configuration, tout ou partie de la source lumineuse 4 peut faire saillie de la surface supérieure de ce substrat et donc de la première couche 10 ou de la face visible 20a du cadran 2a pour former une représentation graphique telle qu'un index, un chiffre, un point, un trait, etc.

Un tel éclairage peut également être un éclairage déporté lorsque ladite au moins une source lumineuse 4 est couplée à au moins un guide d'onde. Ce guide d'onde encore appelé guide de lumière, permet d'amener la lumière depuis le point où elle injectée dans le guide jusque dans le substrat ou jusqu'à une zone du substrat (p. x. : cavité, ouverture traversante) proche de la surface supérieure de ce substrat. Un tel guide de lumière peut être une fibre optique qui permet de contourner les éventuels obstacles qui peuvent se dresser dans le substrat par exemple entre l'élément électroluminescent et la zone du substrat proche de la surface supérieure de ce substrat, par laquelle la lumière va s'échapper. Dans cette variante de réalisation, c'est donc la lumière qui est amenée, via le guide d'onde, depuis l'élément électroluminescent jusqu'à cette zone du substrat à éclairer.

Dans une telle configuration, une première extrémité du guide d'onde est couplée avec la source lumineuse 4 et une deuxième extrémité de ce guide peut être agencée d ns :
- une cavité pouvant être une ouverture borgne réalisée dans la surface inférieure du substrat de cette première couche 10 ; ou
- une ouverture traversante s'étendant dans l'épaisseur du substrat de la première couche 10 en débouchant en ses deux extrémités respectivement dans les surfaces supérieure et inférieure de ce substrat et donc de la première couche 10. Ainsi cette deuxième extrémité peut faire saillie de la surface supérieure du substrat ou de cette première couche 10 ou de la face visible 20a du cadran 2a afin par exemple de former une représentation graphique de ce cadran 2a comme par exemple un élément de repère tel qu'un index, un chiffre, un point, un trait, etc.

Dans ce contexte, l'éclairage indirect peut être réalisé par une seule source lumineuse 4 comprise sur la surface inférieure du substrat de cette première couche 10 en étant couplée à plusieurs guides d'onde dont les deuxièmes extrémités sont agencées d ns :
- des cavités émettant chacune un rayonnement lumineux, provenant de cette source lumineuse 4, ce rayonnement' s'échappant ver' l'extérieur du cadran 2a via la face visible 20a en autorisant ainsi la visualisation d'au moins une représentation graphique dan' l'obscurité. Dans ce contexte, cette représentation graphique comprise dans ou sur la face visible 20a du cadran 2a, ou la surface supérieure du substrat, est de préférence opaque ; et/ou
- des ouvertures traversantes en faisant saillie ou pas de la surface supérieure de ce substrat afin de former des éléments de repères tels qu'un index, trait ou encore un point, et émettant chacune un rayonnement lumineux, provenant de cette source lumineuse 4.

Dans cette première couche 10, le module de signalement 4 est appliquée/fixée sur la surface inférieure du substrat de cette première couche 10, dans une cavité ou sur une paroi interne d'une ouverture traversante évoquée précédemment et ce, par impression ou évaporation. Autrement dit, la source lumineuse de ce module 4 est appliquée/fixée sur la surface inférieure du substrat de cette première couche 10, dans une cavité ou sur une paroi interne d'une ouverture traversante évoquée précédemment et ce, par impression ou évaporation.

Dans cette première couche 10, l'élément récepteur 23 est disposé dans/sur ce substrat afin de pouvoir recevoir des ondes acoustiques présentes dans l'enceinte de la boite de montre 1. Cet élément récepteur 23 peut être agencé sur ou sous la surface supérieure de ce substrat formant la première couche 10. Lorsqu'il est agencé dans le substrat, cet élément récepteur 23 est positionné dans une cavité borgne ménagée dans cette surface supérieure. Dans une variante, il peut être agencé dans une cavité borgne réalisée dans la surface inférieure de ce substrat ayant pour fond cette surface supérieure. Dans cette configuration, les ondes acoustiques se propageant dans le cadran 2a, 2b et dans la face visible 20a peuvent être mesurées par ledit élément récepteur 23. Ce substrat peut aussi comprendre un trou traversant reliant les surfaces supérieure et inférieure entre elles et dans lequel l'élément récepteur 23 peut être agencé.

En outre, on notera que la surface inférieure de cette première couche 10 peut être autocollante afin de participer à son assemblage avec la deuxième couche 11.

Dans cet empilement 9a, la deuxième couche 11 comprend un substrat comportant le module photovoltaïque 5. Un tel substrat est de préférence flexible ou souple. Ce substrat de la deuxième couche 11, peut être un film sur lequel est disposé le module photovoltaïque 5. Enfin, ce substrat peut être réalisé en un matériau appartenant à la famille des polymères.

Dans cette deuxième couche 11, le module photovoltaïque ' s'étend préférentiellement su' l'ensemble d'une zone dite active de la surface supérieure de ce substrat. Cette zone active est une portion de la surface supérieure du substrat qui est apte recevoir la lumière provenant de la surface inférieure de la première couche 10 du cadran 2a. Cette lumière qui a traversé tout ou partie de la première couche 10, provient de l'environnement extérieur du cadran 2a, et donc de la montre 1, ici principalement du rayonnement solaire lorsqu'elle est d'origine naturelle.

On notera que le module photovoltaïque 5 est appliqué sur la surface supérieure de ce substrat à partir de procédés d'impression par jet d'encre ou encore par sérigraphie ou à partir de procédés d'impression par évaporation thermique. On parlera d'ailleurs ici d'une deuxième couche 11 comprenant un module photovoltaïque 5 imprimé. En particulier, d'un module photovoltaïque 5 imprimé sur le substrat de la deuxième couche 11.

On remarquera qu'une fois le module photovoltaïque 5 a été appliqué sur le substrat, une couche d'une substance autocollante peut être déposée sur tout ou partie de la surface supérieure et/ou de la surface inférieure du substrat. Dans ces conditions, la deuxième couche 11 peut être une couche autocollante qui participe à faciliter son assemblage avec les autres couches en particulier avec la première couche 10 et/ou la troisième couche 12 de cet empilement 9a.

Dans l'empilement 9a, cette troisième couche 12 comprend aussi un substrat de préférence flexible ou souple, comportant l'accumulateur d'énergie électrique 6 du dispositif de détermination autonome 3. Ce substrat de la troisième couche 12 peut être un film sur lequel est compris l'accumulateur 6. Un tel substrat peut être réalisé en un matériau appartenant à la famille des polymères.

Cet accumulateur 6 peut être une batterie au lithium ou encore une batterie à semi-conducteurs. Un tel accumulateur 6 est appliqué sur la surface supérieure de ce substrat à partir de procédés connus de l'état de la technique tels que :
- des procédés d'impression sur substrat polymère souple lorsqu'il s'agit par exemple d'une batterie au lithium ; ou
- des procédés d'impression tridimensionnelle lorsqu'il s'agit par exemple d'une batterie à semi-conducteurs telle qu'une batterie lithium-métal à semi-conducteurs.

On parlera d'ailleurs ici d'une troisième couche 12 comprenant un accumulateur d'énergie électrique 6 imprimé. En particulier, d'un accumulateur d'énergie électrique 6 imprimé sur le substrat de la troisième couche 12.

Ainsi, de tels procédés permettent d'obtenir une troisième couche 12 comprenant cet accumulateur 6 qui est souple et ultrafine.

En outre, on remarquera qu'une fois l'accumulateur 6 appliqué sur le substrat, une couche d'une substance autocollante peut être déposée sur tout ou partie de la surface supérieure et/ou de la surface inférieure de ce substrat. Dans ces conditions, la troisième couche 12 peut être une couche autocollante qui participe à faciliter son assemblage avec les autres couches en particulier avec la deuxième couche 11 et/ou la quatrième couche 13 de cet empilement 9a.

On notera que cet accumulateur 6 sert à stocker l'énergie électrique produite par le module photovoltaïque 5 et à la restituer sur demande pour alimenter le dispositif de détermination 3 en particulier le module de signalement 4 et ledit au moins un élément récepteur 23.

Dans cet empilement 9a, cette quatrième et dernière couche 13 forme la face cachée du cadran 2a. Une telle quatrième couche 13 est formée par un substrat de préférence flexible ou souple, comportant l'unité de contrôle 7. Un tel substrat de la quatrième couche 13, peut être par exemple un PCB flexible sur lequel est agencée cette unité de contrôle 7 en particulier sur la surface supérieure de ce PCB et donc du substrat. Dans ce contexte, l'édification de l'unité de contrôle 7 sur cette surface supérieure du substrat peut être réalisée à partir de procédés d'impression tridimensionnelle ou encore des procédés d'impression sur polymère.

Dans cette dernière et quatrième couche 13, l'élément récepteur 23 est disposé dans/sur ce substrat afin de pouvoir recevoir des ondes acoustiques présentes dans l'enceinte de la boite de montre 1. Cet élément récepteur 23 peut être agencé sur ou sous la surface inférieure de ce substrat formant cette quatrième couche 13. Lorsqu'il est agencé dans le substrat, cet élément récepteur 23 est positionné dans une cavité borgne ménagée dans cette surface inférieure. Dans une variante, il peut être agencé dans une cavité borgne réalisée dans la surface supérieure de ce substrat ayant pour fond cette surface inférieure. Dans cette configuration, les ondes acoustiques se propageant dans le cadran 2a, 2b et dans la face cachée 20b peuvent être mesurées par ledit élément récepteur 23. Ce substrat peut aussi comprendre un trou traversant reliant les surfaces supérieure et inférieure entre elles et dans lequel l'élément récepteur 23 peut être agencé.

Dans la deuxième variante, l'empilement 9b formant le cadran 2b, comprend trois couches minces/fines 10, 11, 14, reliées entre elles. On remarquera que cette deuxième variante se différencie de la première variante en ce qu'elle comprend donc trois couches 10, 11, 14 au lieu de quatre couches 10, 11, 12, 13, comme dans la première variante. Dans cette deuxième variante, l'accumulateur d'énergie électrique 6 du dispositif de détermination 3 est maintenant compris dans la troisième et dernière couche 14 de cet empilement 9b avec l'unité de contrôle 7.

Une telle troisième et dernière couche 14 de cet empilement 9b, formant la face cachée du cadran 2b, est constituée d'un substrat de préférence flexible ou souple, sur lequel sont édifiés, de préférence sur la surface supérieure de ce substrat, l'accumulateur 6 et le circuit électronique 8 constituant l'unité de contrôle 7. Une telle édification de l'accumulateur 6 et de l'unité de contrôle 7 sur cette surface supérieure du substrat, peut être réalisée à partir de procédés d'impression tridimensionnelle ou encore des procédés d'impression sur polymère. On notera qu'un tel substrat peut être par exemple un PCB flexible.

Dans cette dernière et troisième couche 14 de cette deuxième variante, l'élément récepteur 23 est disposé dans/sur ce substrat afin de pouvoir recevoir des ondes acoustiques présentes dans l'enceinte de la boite de montre 1. Cet élément récepteur 23 peut être agencé sur ou sous la surface inférieure de ce substrat formant la troisième couche 14. Lorsqu'il est agencé dans le substrat, cet élément récepteur 23 est positionné dans une cavité borgne ménagée dans cette surface inférieure. Dans une variante, il peut être agencé dans une cavité borgne réalisée dans la surface supérieure de ce substrat ayant pour fond cette surface inférieure. Dans cette configuration, les ondes acoustiques se propageant dans le cadran 2a, 2b et dans la face cachée 20b peuvent être mesurées par ledit élément récepteur 23. Ce substrat peut aussi comprendre un trou traversant reliant les surfaces supérieure et inférieure entre elles et dans lequel l'élément récepteur 23 peut être agencé.

En résumé dans cette deuxième variante, l'empilement 9b comprend alors :
- une première couche 10 formant la face visible 20a du cadran 2b incluant ledit au moins un élément récepteur 23 et/ou le module de signalement 4 ;
- une deuxième couche 11 incluant le module photovoltaïque 5 ; et
- la troisième couche 14 formant la face cachée 20b du cadran 2b incluant ledit au moins un élément récepteur 23 et/ou l'accumulateur 6 et l'unité de contrôle 7.

On notera que dans cette deuxième variante, les première et deuxième couches 10, 11 sont similaires à celles de la première variante de l'empilement 9a.

Par ailleurs, en référence aux figures 3 et 5, le circuit électronique 8 de l'unité de contrôle 7 comprend des premiers éléments de connexion 15a qui sont reliés à des éléments de connexion 16 de :
- le module de signalement 4 pour la gestion du fonctionnement de ce module 4 notamment pour la diffusion d'un message relatif à l'évènement acoustique déterminé ; et
- audit au moins un élément récepteur 23 pour participer à la détermination de l'évènement acoustique.

Ce circuit électronique 8 comprend aussi des deuxièmes éléments de connexion 15b reliés à des premiers éléments de connexion 17a de l'accumulateur 6.

En outre, on notera que les capteurs d'évènements du dispositif de détermination 3, évoqués précédemment sont de préférence agencés dans la première couche 10 et/ou la dernière couche 13, 14 de l'empilement 9a, 9b de couches en étant reliés à l'unité de contrôle 7 de ce dispositif 3.

Dans une troisième variante non représentée, l'empilement de couches minces/fines formant le cadran comprend deux couches reliées entre elles. On remarquera que cette troisième variante se différencie de la deuxième variante en ce qu'elle comprend donc deux couches au lieu de trois couches 10, 11, 14, comme dans cette deuxième variante. Dans cette troisième variante, le module photovoltaïque 5 du dispositif de détermination autonome 3 est maintenant compris dans la première couche et en particulier sur la surface inférieure du substrat formant cette première couche. Ce module photovoltaïque 5 peut être appliqué sur cette surface inférieure du substrat de cette première couche à partir de procédés d'impression par jet d'encre ou encore par sérigraphie ou à partir de procédés d'impression par évaporation thermique. On notera donc que cette première couche est alors similaire aux premières couches 11 des première et deuxième variantes, à l'exception du fait que dans cette troisième variante, la première couche comprend en plus le module photovoltaïque.

Par ailleurs dans la troisième variante, et de manière similaire à la deuxième variante, l'accumulateur d'énergie électrique 6 du dispositif de détermination autonome 3 est compris dans la deuxième et dernière couche de cet empilement avec l'unité de contrôle 7. Une telle deuxième couche formant la face cachée du cadran, est constituée d'un substrat de préférence flexible ou souple, sur lequel sont édifiés, de préférence sur la surface supérieure de ce substrat, l'accumulateur 6 et le circuit électronique 8 constituant l'unité de contrôle 7. Cette édification de l'accumulateur 6 et de l'unité de contrôle 7 sur la surface supérieure du substrat, peut être réalisée à partir de procédés d'impression tridimensionnelle ou encore des procédés d'impression sur polymère. On notera qu'un tel substrat peut être par exemple un PCB flexible.

En résumé dans cette troisième variante, l'empilement de couches comprend alors :
- une première couche formant la face visible 20a du cadran incluant ledit au moins un élément récepteur 23 et/ou le module de signalement 4 et le module photovoltaïque 5 ; et
- une deuxième couche formant la face cachée 20b du cadran incluant ledit au moins un élément récepteur 23 et/ou l'accumulateur 6 et l'unité de contrôle 7.

Dans les dernières couches 13, 14 des différentes variantes, le module émetteur-récepteur 23 est appliquée/fixée sur la surface inférieure ou supérieure du substrat de ces couches, dans une cavité ou sur une paroi interne d'une ouverture traversante évoquée précédemment, par impression ou évaporation.

Ainsi dans ce cadran 2a, 2b, le dispositif de détermination 3 comprend l'élément récepteur 23 qui convertit l'onde acoustique reçue en un signal électrique qui est transmis à l'unité de contrôle 7. Ainsi lorsqu'au moins une onde acoustique est générée par un composant horloger ou un mécanisme horloger, un signal électrique comprenant des données relatives à un ou plusieurs ondes acoustiques reçue (s), est alors transmis par l'élément récepteur 23 à l'unité de contrôle 7. Cette unité de contrôle 7 effectue alors un traitement de ces données sur la base de l'algorithme de détermination d'un évènement acoustique. Un tel traitement permet d'identifier l'évènement acoustique en fonction notamment de caractéristiques d'au moins une onde acoustique captée par l'élément récepteur 23 à savoir : la période, la fréquence, la longueur d'onde, la puissance acoustique, l'intensité acoustique, la pression acoustique et/ou la durée de cette dite au moins une onde acoustique.

Une telle détermination d'un évènement acoustique peut permettre à ce cadran 2a, 2b de mettre en oeuvre diverses fonctions de cette montre. Par exemple, une fonction de cette montre peut correspondre à une détection d'un choc subit par un composant horloger comme un composant de la boite, tel que la carrure, la glace, ou la couronne de la montre 1 qui peut entrainer une perte de précision du chronométrage. En effet, il peut arriver qu'en raison des chocs subis par la montre le fonctionnement du mécanisme s'en trouve perturbé. Ceci a pour conséquence que, bien qu'une horloge interne de la montre fournisse une indication juste de l'heure courante, les aiguille' d'heures et de minutes fournissent une indication faussée de cette heure courante, car les rouages ont sauté de quelques pas sou' l'effet du choc appliqué à la montre. Il est donc nécessaire de resynchroniser la position des aiguille' d'heures et de minutes. Dès lors dans le cadre de cette fonction, l'unité de contrôle 7 peut générer un message visuel, vibrant et/ou sonore en fonction donc de cet évènement qui signale cette perte de précision par le contrôle/pilotage du module de signalement 4.

D'autres fonctions de la montre utilisant la détermination d'un évènement acoustique, peuvent être de manière non limitative et non exhaustive :
- un passage (ou d'un non-passage) de l'indicateur quantième peut être capté par l'élément récepteur 23. Une source lumineuse peut ensuite être mise en oeuvre pour signaler l'évènement fau if ;
- un arrêt dans un cran de mécanisme, par exemple dans le mécanisme de mise à l'heure de la montre 1, peut être capté par l'élément récepteur 23. Au moins une source lumineuse peut ensuite être mise en oeuvre pour signaler la position dans laquelle se trouve le mécanisme, par exemple la position de correction de l'heure ou la position de correction de l'indicateur de quanti me ;
- une séquence de choc prédéfinie peut être captée par l'élément récepteur 23, par exemple dans le but d'enclencher ou de déclencher une source lumineuse 4 ou d'en modifier la couleur d'éclairage ;
- une séquence de tapotements sur la glace de la montre 1 peut permettre d'illuminer le cadran 2a, 2b ou de rétroéclairer les aiguilles afin de rendre l'heure visible durant la nuit, une autre séquence de tapotements peut permettre de modifier la couleur d'éclairage de ladite au moins une source lumineuse active ;
- une déviation dans une fréquence monitorée par l'élément récepteur 23 peut être signalée par la mise en oeuvre d'au moins une source lumineuse. Cette variation de cette fréquence pouvant indiquer un dysfonctionnement présent ou à venir.

Il va de soi que la présente invention n'est pas limitée aux modes de réalisation qui viennent d'être décrits et que diverses modifications et variantes simples peuvent être envisagées par l'homme du métier sans sortir du cadre de l'invention tel que défini par les revendications annexées.

## Revendications

1. Cadran (2a, 2b) de montre (1) comprenant un dispositif de détermination d'un évènement acoustique autonome (3), un tel cadran (2a, 2b) comprend une face visible (20a) et une face cachée (20b), ledit cadran (2a, 2b) étant formé par un empilement (9a, 9b) de couches minces (10, 11, 12, 13, 14) de matière s'étendant entre ces deux faces (20a, 20b), chacune desdites couches (10, 11, 12, 13, 14) comprenant un ou plusieurs des éléments fonctionnels compris dans ledit dispositif 3 :
- au moins un élément récepteur (23) d'au moins une onde acoustique provenant de la montre (1) ;
- un module de signalement de l'évènement acoustique (4) ;
- une unité d'alimentation électrique autonome (21) ; et
- une unité de contrôle (7) pour gérer le fonctionnement dudit module de signalement (4) et dudit au moins un élément récepteur (23) d'au moins une onde acoustique.

2. Cadran (2a, 2b) selon la revendication précédente, dans lequel ledit au moins un élément récepteur (23) comprend un microphone à pression et/ou un microphone à gradient de pression.

3. Cadran (2a, 2b) selon l'une quelconque des revendications précédentes, dans lequel le module de signalement de l'évènement acoustique comprend :
- au moins un élément susceptible de générer un signal lumineux (4) ;
- au moins un élément susceptible de générer un signal vibratoire ; et/ou
- au moins un élément susceptible de générer un signal sonore.

4. Cadran (2a, 2b) selon l'une quelconque des revendications précédentes, dans lequel l'empilement (9a, 9b) de couches minces (10, 11, 12, 13, 14) de matière comprend une première couche (10) pourvue de la face visible (20a) du cadran (2a, 2b) et la première couche (10) comprenant ledit au moins un élément récepteur (23) et ledit module de signalement (4).

5. Cadran (2a, 2b) selon l'une quelconque des revendications précédentes, dans lequel ledit au moins un élément récepteur (23) est agencé dans une cavité ménagée dans la face cachée de ce cadran (2a, 2b).

6. Cadran (2a, 2b) selon l'une quelconque des revendications précédentes, dans lequel ladite première couche (10) est configurée pour être traversé en tout ou partie par un rayonnement lumineux notamment par un rayonnement solaire.

7. Cadran (2a, 2b) selon l'une quelconque des revendications précédentes, dans lequel ladite première couche (10) est en tout ou partie transparente ou translucide.

8. Cadran (2a, 2b) selon l'une quelconque des revendications précédentes, dans lequel l'empilement (9a, 9b) de couches minces (10, 11, 12, 13, 14) de matière comporte une deuxième couche (11) comprenant un module photovoltaïque (5) constituant l'unité d'alimentation électrique autonome (21).

9. Cadran (2a, 2b) selon l'une quelconque des revendications précédentes, dans lequel la deuxième couche (11) comprend un substrat sur lequel le module photovoltaïque (5) est imprimé.

10. Cadran (2a, 2b) selon l'une quelconque des revendications 7 et 8, dans lequel ledit module photovoltaïque (5) est disposé sur une zone active de ladite deuxième couche (11), ladite zone étant configurée pour recevoir des rayonnements lumineux provenant de la première couche (10) de l'empilement (9a, 9b) de couches minces (10, 11, 12, 13, 14) de matière.

11. Cadran (2a) selon l'une quelconque des revendications précédentes, dans lequel l'empilement (9a) comporte une troisième couche (12) comprenant un accumulateur d'énergie électrique (6) constituant l'unité d'alimentation électrique (21) autonome.

12. Cadran (2a) selon la revendication précédente, dans lequel la troisième couche (12) comprend un substrat sur lequel l'accumulateur d'énergie électrique (6) est imprimé.

13. Cadran (2a) selon l'une quelconque des revendications précédentes, dans lequel l'empilement (9a) comporte une quatrième couche (13) formant une face cachée (20b) du cadran (2a) comprenant l'unité de contrôle (7).

14. Cadran (2b) selon l'une quelconque des revendications 1 à 10, dans lequel l'empilement (9b) comporte une troisième couche (14) comprenant une face cachée (20b) du cadran (2a) comportant l'unité de contrôle (7) et un accumulateur d'énergie électrique (6) constituant l'unité d'alimentation électrique (21) autonome.

15. Cadran (2a, 2b) selon l'une quelconque des revendications précédentes, dans lequel la première couche (10) est rigide relativement aux autres couches (11, 12, 13, 14) comprises dans l'empilement (9a, 9b) de couches minces (10, 11, 12, 13, 14) de matière qui sont souples.

16. Cadran (2a, 2b) selon l'une quelconque des revendications précédentes, dans lequel lesdites faces visible et cachée (20a, 20b) sont planes ou bombées.

17. Montre (1) comprenant un cadran (2a, 2b) selon l'une quelconque des revendications précédentes.

18. Montre (1) selon la revendication précédente, **caractérisée en ce qu'**elle comprend un mouvement horloger mécanique, électronique ou électromécanique.
